# FASCICULE DE BREVET EUROPEEN

(11) **EP 2 071 628 B1**
(45) Date de publication et mention de la délivrance du brevet: **08.10.2014**
(21) Numéro de dépôt: 08170970.1
(22) Date de dépôt: 08.12.2008
(51) Int. Cl.: H01L 27/146, H01L 31/107

(54) **Dispositif microélectronique photosensible avec multiplicateurs par avalanche**
Fotosensible mikroelektronische Vorrichtung mit Lawinenmultiplikatoren
Photosensitive microelectronic device with avalanche multipliers

(30) Priorité: 10.12.2007 FR 0759730
(43) Date de publication de la demande: 17.06.2009
(73) Titulaire: Commissariat à l'Énergie Atomique et aux Énergies Alternatives, 75015 Paris (FR)
(72) Inventeur: Carriere, Nicolas, 38000 Grenoble (FR)
(74) Mandataire: Ilgart, Jean-Christophe

(56) Documents cités:
- WO-A-2004/019609
- JP-A- 7 030 816
- US-A1- 2004 262 651
- US-A1- 2006 175 536
- US-A1- 2007 176 213

## Description

### DOMAINE TECHNIQUE

La présente invention est relative au domaine des dispositifs microélectroniques imageurs ou capteurs d'image, en particulier en technologie CMOS.

L'invention concerne un dispositif microélectronique photosensible ainsi qu'un capteur d'image doté de pixels formés d'un dispositif microélectronique photosensible comprenant une zone photosensible associée à des moyens multiplicateurs d'électrons par avalanche électronique comportant une pluralité de grilles de contrôle.

L'invention apporte des améliorations notamment en termes de gain et de sensibilité par rapport aux matrices CMOS classiques, tout en permettant de fonctionner avec une tension d'alimentation inférieure à celle des matrices CCD suivant l'art antérieur.

L'invention apporte des améliorations notamment en termes dynamique d'image et de protection contre des effets de saturation par rapport aux matrices suivant l'art antérieur.

### ÉTAT DE LA TECHNIQUE ANTÉRIEURE

On cherche généralement à intégrer un nombre de pixels de plus en plus important au sein des dispositifs imageurs de type CMOS (CMOS pour « complementary metal oxide semiconductor ») ou CCD (CCD pour « charge coupled device » ou dispositif à couplage de charge). Ainsi, la taille des pixels au sein de tels dispositifs est de plus en plus réduite, ce qui oblige à effectuer une détection avec un nombre de photons collectés de moins en moins important.

Dans un dispositif matriciel de type CCD, les charges sont transférées d'un pixel pᵢ à l'autre pᵢ₊₁, de manière à traverser la matrice 10 photosensible et à atteindre un circuit de lecture qui peut être sous forme d'un convertisseur charge-tension 20 situé à l'extérieur de la matrice. L'efficacité de chaque transfert de charge est un élément critique dans la mesure où une perte lors d'un transfert d'électrons peut rapidement conduire à un rendement nul après une centaine de transferts. Pour minimiser les pertes, d'importantes contraintes de réalisation, par exemple telles que le dopage du substrat sur lequel est réalisé la matrice, sont prévues, et rendent ces matrices incompatibles avec un fonctionnement à avalanche à basse tension.

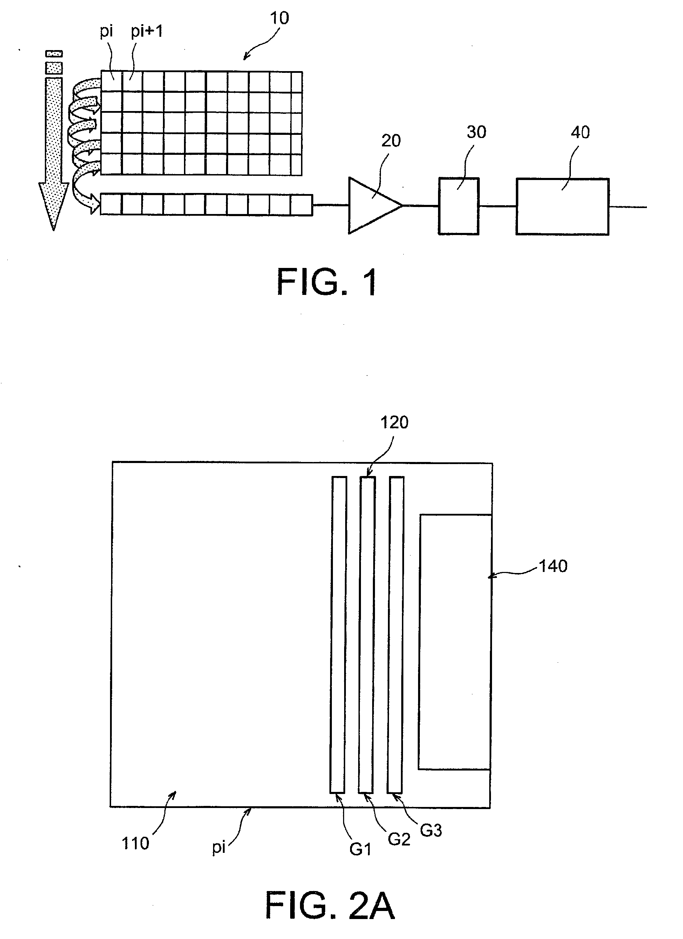

Dans une matrice CCD à avalanche classique, pour multiplier le nombre d'électrons collectés, on rajoute un multiplicateur 30 entre le circuit de lecture 20 et un convertisseur analogique numérique 40. Le signal issu de chacun des pixels traverse alors le même multiplicateur 30 (figure 1).

Afin de garder une bonne sensibilité de détection, ainsi qu'un bon rapport signal à bruit, il peut être alors intéressant d'amplifier le signal photogénéré avant de le lire.

Un moyen pour multiplier le nombre d'électrons collectés est d'utiliser le phénomène d'ionisation par impact, dans lequel un fort champ électrique permet d'accélérer suffisamment les électrons pour ioniser un semi-conducteur et lui arracher des électrons supplémentaires. De tels moyens sont mis en oeuvre dans les capteurs réalisés en technologie CCD et décrits dans le document : « Experimental Observation of Avalanche Multiplication in Charge-Coupled Devices », Madan et al., juin 1983. Pour chaque transfert, le gain obtenu peut être alors de l'ordre de 1 %.

Les imageurs CMOS se différencient fondamentalement des capteurs CCD, en ce que le circuit de lecture, par exemple un convertisseur de charge/tension, est réalisé au sein d'un pixel, tandis que pour un capteur CCD, les charges sont transférées à l'extérieur de la matrice avant d'être lues.

Les imageurs CMOS ont pour avantages de présenter une faible consommation, une bonne rapidité, et de permettre de co-intégrer circuits analogiques et numériques sur une même puce. Les progrès sur les circuits de lecture des imageurs CMOS ont en outre permis de rabaisser le niveau de bruit d'un imageur CMOS au niveau de celui d'un imageur CCD.

Cependant, la réalisation de pixels dotés de moyens d'amplification est délicate. La réalisation d'une matrice de photodiodes à avalanche, est connue mais pose de nombreux problèmes, tels que la nécessité d'une alimentation haute tension, typiquement de l'ordre de 70V, et celle d'un système de refroidissement. Par ailleurs, avec un tel dispositif, il est difficile de réduire la taille des pixels.

Il est également connu de réaliser un pixel, en superposant, sur le circuit de lecture, une couche permettant à la fois de faire la conversion photon/électron et de multiplier les électrons. Les couches utilisées sont généralement de type HARP (HARP pour « high gain avalanche rushing amorphous photoconductor »). Une telle architecture est présentée dans le document WO 2004/019609 A2, et a pour inconvénient de nécessiter une tension d'alimentation importante, typiquement de l'ordre de 70V, ce qui implique de devoir protéger les circuits logiques fonctionnant quant à eux à basse tension, par exemple de l'ordre de 5 Volts.

Le document US 2007/0176213 A1 concerne un dispositif microélectronique matriciel capteur d'image comportant une pluralité de cellules élémentaires agencées selon une matrice de cellules dotées d'une zone photosensible de capture de (s) photon (s) et de conversion de(s) photon(s) en électron(s), de moyens multiplicateur par avalanche électronique, prévus pour produire un nombre d'électrons plus important que le nombre d'électrons convertis par la zone photosensible, les moyens multiplicateurs étant formés d'électrodes de grilles.

Dans les deux types d'architectures, CCD à avalanche et CMOS de type HARP, seule la tension d'alimentation permet de contrôler le gain du pixel, ce qui entraine une forte dispersion du gain entre les pixels dans les imageurs de grande taille.

Il se pose le problème de trouver un nouveau dispositif imageur dotés de moyens amplificateurs intégrés aux pixels, et qui ne comporte pas les inconvénients évoqués ci-dessus.

### EXPOSÉ DE L'INVENTION

L'invention concerne un dispositif microélectronique matriciel capteur d'image selon la revendication 1 et un procédé de commande d'un tel dispositif selon la revendication 19.

Lors de cycle(s) de multiplication, les moyens multiplicateurs ont un gain donné, souhaité, et qui est adapté par le circuit de commande.

Les grilles des moyens multiplicateurs sont polarisées, lors d'un ou plusieurs cycles de multiplication, de manière à faire faire à un groupe d'électrons, un ou plusieurs aller(s)-retour(s) dans une zone semi-conductrice située en regard desdites grilles de contrôle.

Le gain des moyens multiplicateurs peut être réglable.

Ce gain est modifié ou réglé par l'intermédiaire du circuit de commande.

Une matrice dotée de cellules comportant des moyens multiplicateurs avec un gain réglable peut être ainsi mise en oeuvre.

La séquence ou les séquences sont mises en oeuvre et modifiées par exemple à l'aide du circuit de commande qui peut être par exemple sous forme d'au moins un circuit logique.

Le circuit de commande des dites grilles est configuré pour appliquer des signaux de commande à chacune des dites grilles des moyens multiplicateurs selon une séquence prédéterminée, et est configuré pour modifier ladite séquence prédéterminée.

Le circuit de commande est adapté pour appliquer des premiers signaux de commande aux grilles de moyens multiplicateurs d'au moins une première cellule de la matrice, et à appliquer des deuxième signaux de commande, différents des dits premiers signaux, aux grilles de moyens multiplicateurs d'au moins une deuxième cellule de la matrice.

Ainsi, un gain de multiplication différent est appliqué d'une cellule à l'autre de la matrice. Cela peut permettre d'augmenter la dynamique de l'image.

Cela permet également de ne pas saturer certains pixels qui sont fortement saturés et d'adapter le gain de ces pixels de manière indépendante entre eux.

On applique par exemple un premier gain de multiplication, par exemple un gain de multiplication élevé, à une ou plusieurs cellules ayant reçues un premier nombre de photons ou un nombre de nombre de photons inférieur à un nombre de photons donné, et appliquer un deuxième gain de multiplication, par exemple un gain de multiplication faible, à une ou plusieurs cellules ayant reçues un deuxième nombre de photons supérieur au premier nombre ou supérieur au nombre de photons donné.

Le circuit de commande des dites grilles des moyens multiplicateurs d'une cellule, peut être prévu pour appliquer au moins un premier signal de commande à une première grille des moyens de multiplication d'une cellule donnée, au moins un deuxième signal de commande des dits moyens de multiplication de ladite cellule donnée, au moins un troisième signal de commande à une troisième grille des dits moyens de multiplication de ladite cellule donnée, le premier signal suivant une première séquence, le deuxième signal suivant une deuxième séquence, et le troisième signal suivant une troisième séquence, la première séquence, la deuxième séquence, la troisième séquence étant prévues en fonction d'un gain de multiplication souhaité.

Le circuit de commande des dites grilles est adapté pour modifier la première séquence, la deuxième séquence, et la troisième séquence, en fonction du gain souhaité.

Pour obtenir des gains différents entre la première cellule et la deuxième cellule, les premiers signaux appliqués aux moyens multiplicateurs de la première cellule peuvent suivre des premières séquences, tandis que les deuxièmes signaux appliqués aux moyens multiplicateurs de la deuxième cellule suivent des deuxièmes séquences, différentes des premières séquences.

Les deuxièmes séquences peuvent être une répétition d'un nombre donné X, de fois les premières séquences.

Les moyens de multiplications d'électrons peuvent être dotés de 3 grilles ou d'au moins 3 grilles.

Les grilles des moyens multiplicateurs peuvent être commandées lors d'un ou plusieurs premiers cycles de multiplication, de manière à faire faire à un groupe d'électrons, un premier nombre donné d'aller(s)-retour(s) dans une zone semi-conductrice située en regard desdites grilles de contrôle, et être commandées, lors d'un ou plusieurs autres cycles de multiplication, de manière à faire faire à un groupe d'électrons, un nombre d'aller(s)-retour(s) différent dudit premier nombre donné.

Selon une possibilité de mise en oeuvre, le circuit de commande peut être apte à appliquer au moins une première séquence de signaux de commande aux grilles de moyens multiplicateurs d'au moins une première cellule de la matrice, et à appliquer au moins une deuxième séquence de signaux de commande, différente de la première séquence, aux grilles de moyens multiplicateurs d'au moins une deuxième cellule de la matrice.

Au moins plusieurs cellules peuvent comprendre en outre chacune : au moins un circuit de lecture, le circuit de lecture comprenant, ou étant formé, d'au moins un convertisseur charge/tension ou d'au moins un convertisseur charge/courant.

Selon une possibilité, les moyens multiplicateurs peuvent être intégrés dans le circuit de lecture.

Le circuit de lecture peut être prévu pour effectuer au moins une lecture d'une quantité de charge(s) produite par ladite zone photosensible, préalablement à un cycle de multiplication de cette quantité de charge.

Suite à cette lecture, et préalablement à un cycle de multiplication le gain de multiplication peut être adapté, en fonction de la lecture effectuée, c'est-à-dire de la quantité de charge produite par la zone photosensible.

Le circuit de lecture peut être prévu pour effectuer une lecture périodique de la quantité de charge(s) produite par ladite zone photosensible.

Ledit circuit de commande peut être prévu pour, après une lecture effectuée par le circuit de lecture, modifier le gain d'une ou plusieurs cellules données de la matrice.

Selon une possibilité, le dispositif microélectronique capteur d'image peut comprendre en outre : des moyens d'échantillonnage multiple corrélé.

Selon une possibilité de mise en oeuvre, la zone photosensible peut recouvrir les grilles des moyens multiplicateurs. L'encombrement des pixels ou cellules élémentaires peut être ainsi réduit.

La zone photosensible peut être située sur une face donnée ou d'un côté donné d'un substrat, les grilles des moyens multiplicateurs étant formés sur ladite face donnée ou sur ledit côté donné dudit substrat.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1, illustre un exemple de dispositif imageur CCD à avalanche suivant l'art antérieur,
- les figures 2A et 2B, illustrent un exemple de pixel d'un dispositif imageur suivant l'invention, et une matrice de pixels d'un imageur suivant l'invention,
- la figure 3, illustre, un exemple de dispositif imageur doté de moyens multiplicateurs par avalanche électronique comportant plusieurs grilles de contrôle, le dispositif étant représenté selon une vue en coupe,
- les figures 4A-4F, illustrent un exemple de fonctionnement de moyens multiplicateurs par avalanche électronique, au sein d'un dispositif imageur suivant l'invention,
- la figure 5, représente un exemple de chronogramme de fonctionnement des signaux de contrôle de moyens multiplicateurs par avalanche électronique, au sein d'un dispositif imageur suivant l'invention,
- les figures 6A-6B, illustrent, des variantes d'agencement de moyens multiplicateurs par avalanche électronique dans un dispositif imageur suivant l'invention,
- la figure 7, illustre, un exemple de dispositif microélectronique à détecteur photosensible doté de moyens multiplicateurs par avalanche électronique comportant plusieurs grilles de contrôle, le dispositif étant représenté selon une vue de dessus.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de dispositif microélectronique matriciel imageur suivant l'invention, est représenté sur la figure 2A. Ce dispositif comprend une matrice 100 de n rangées horizontales et m rangées verticales de cellules élémentaires également appelés pixels pᵢ avec n qui peut être égal à m, et par exemple compris entre 1 et 10000, par exemple égal à 2000.

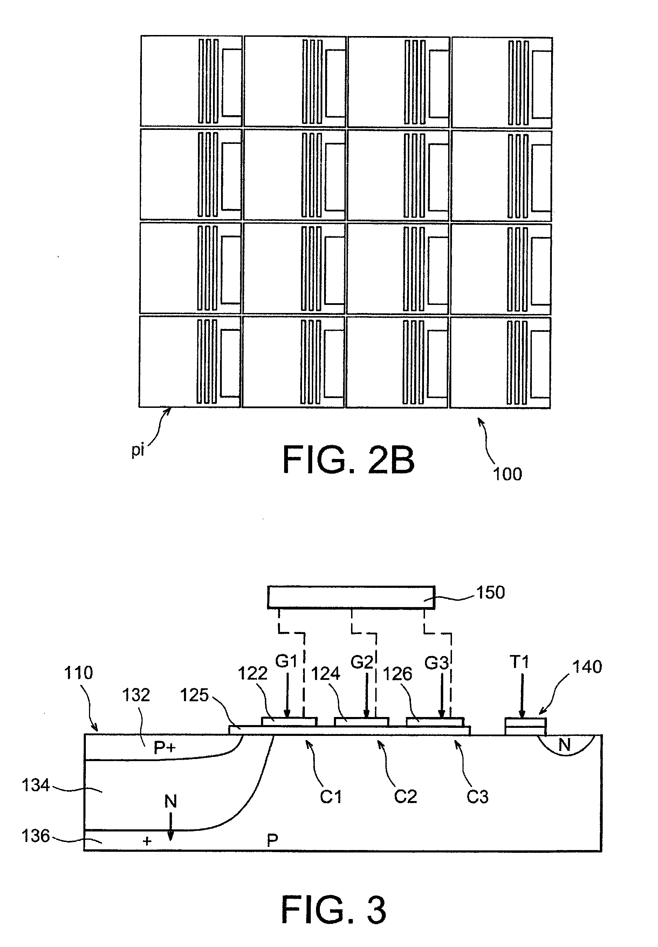

Les cellules élémentaires ou pixels pᵢ (figure 2B) peuvent être réalisé(e)s en technologie CMOS et avoir une taille par exemple de l'ordre de 1 ou plusieurs micromètres de côté d, et comprennent respectivement, au moins une zone photosensible 110, prévue pour la capture de(s) photon(s) et la conversion de(s) photon(s) en électron(s).

Les cellules élémentaires ou pixels pᵢ sont également dotées chacune de moyens pour augmenter ou amplifier le nombre d'électrons convertis par la zone photosensible, et que l'on appellera un « multiplicateur 120 d'électrons ». Un tel multiplicateur met en oeuvre des processus d'avalanche électronique, et est prévu pour augmenter le nombre d'électrons convertis par la zone photosensible 110, à l'aide d'ionisation(s) par impact(s), lors de cycles dits « de multiplication » ou « d'amplification » d'électrons.

Un tel multiplicateur 120 peut être formé de capacités CMOS. Le multiplicateur 120 comprend au moins deux grilles de contrôle, de préférence au moins 3 grilles G1, G2, G3 de contrôle, qui peuvent être sous forme d'électrodes juxtaposées formées en regard ou au-dessus d'une zone semi-conductrice dans laquelle les électrons sont destinés à circuler. Les grilles G1, G2, G3, permettent, suivant la manière dont elles sont polarisées, de déplacer lesdits électrons dans ladite zone semi-conductrice et de leur faire faire, un ou plusieurs allers-retours dans cette zone semi-conductrice, tout en produisant à chaque aller-retour, un ou plusieurs processus d'ionisation par impact.

Les grilles G1, G2, G3, sont destinées à recevoir chacune un signal de commande issu d'un circuit de commande extérieur 150. Le circuit de commande 150 peut être intégré sur la même puce ou le même substrat que l'imageur ou être éventuellement réalisé sur un autre support.

Lors d'une phase de multiplication, chaque grille peut être destinée à recevoir un signal de commande selon une séquence d'amplitude(s) prédéterminée, différente de celle des autres signaux de commandes reçus par les autres grilles du multiplicateur. Des différences de potentiels entre les grilles peuvent permettre d'effectuer des transferts d'électrons d'un endroit à un autre de la zone semi-conductrice, et de générer de nouveaux électrons par ionisation par impact lors de ces transferts.

Le rapport entre le nombre d'électrons convertis par la zone photosensible et en entrée du multiplicateur, et le nombre d'électrons en sortie du multiplicateur 120, donne le gain dit « d'amplification » ou « de multiplication » du multiplicateur 120. Par exemple pour un gain de 2 % à chaque transfert, après 235 transferts, le nombre d'électrons produits par la zone photosensible 110 peut être multiplié par 100.

Le gain de multiplication d'une cellule peut être adapté ou modulé par le circuit de commande 150.

Des gains de multiplication différents sont également appliqués d'une cellule à l'autre de la matrice.

Les cellules élémentaires ou pixels pᵢ peuvent être également dotées d'un circuit de lecture 140. Le circuit de lecture 140 peut être, ou peut comprendre, par exemple, au moins un convertisseur charge/tension pour convertir une quantité de charges issues du multiplicateur 120 en une tension électrique.

Selon une autre possibilité, le circuit de lecture peut être, ou peut comprendre, par exemple, au moins un convertisseur charge/courant pour convertir une quantité de charges issues du multiplicateur 120 en un courant électrique.

Le circuit de lecture 140 peut être formé d'une pluralité de transistors, par exemple de 3 transistors (le circuit de lecture étant alors qualifié de circuit « 3T ») ou de 4 transistors (le circuit de lecture étant alors qualifié de circuit « 4T »). La tension convertie par le circuit de lecture peut être ensuite acheminée par le biais d'interconnexions à un convertisseur analogique-numérique (non représenté).

Sur la figure 3, une vue en coupe transversale d'un pixel pᵢ d'un imageur, formé dans un substrat 100, est donnée.

Le multiplicateur 120 est formé dans cet exemple, de 3 capacités MOS juxtaposées comprenant respectivement une grille, une zone de diélectrique de grille, et une zone de canal. Les grilles G1, G2, G3 du multiplicateur 120 peuvent être par exemple sous forme de zones disjointes 122, 124, 126 à base de polysilicium ou d'ITO (ITO pour « Indium Titanium Oxyde »), et séparées d'une zone semi-conductrice 130 par exemple à base de silicium, ou de germanium par une couche de matériau diélectrique 125, par exemple à base d'oxyde de silicium, ou de HfO₂, sur laquelle reposent ces zones 122, 124, 126.

Une réalisation des grilles G1, G2, G3, du multiplicateur 120 d'électrons à l'aide d'un matériau conducteur transparent, tel que par exemple de l'ITO peut permettre de maximiser la surface de la zone éclairée.

La zone semi-conductrice peut être dopée de manière à ce qu'un canal de conduction puisse être créé sous les grilles G1, G2, G3. Le canal peut être « surfacique » c'est-à-dire réalisé en surface du substrat, ou « enterré », de sorte qu'une épaisseur non-nulle existe entre la surface du substrat et le canal.

La zone photosensible 110 peut être par exemple une photodiode.

Dans cet exemple, le substrat comporte une première zone dopée 132, par exemple dopée P+, en surface du substrat 100, au dessus d'une deuxième zone dopée 134, par exemple dopée N, et formant une jonction avec la première zone 132, ainsi que d'une troisième zone dopée 136, par exemple dopée P au-dessous de la deuxième zone dopée 134. Le dispositif comporte ainsi une première zone de canal C1 en regard de la première grille G1, une deuxième zone de canal C2 en regard de la deuxième grille G2, et une troisième zone de canal C3 en regard de la troisième grille G3. Les paires électrons-trous photogenérées sont séparées dans une zone de charge d'espace, puis traversent le multiplicateur 120 où le nombre d'électrons est augmenté avant d'être convertis en une tension par le circuit de lecture 140.

Sur la figure 3, un transistor noté T1 formé à côté des grilles G1, G2, G3, et appartenant au circuit de lecture 130, est représenté.

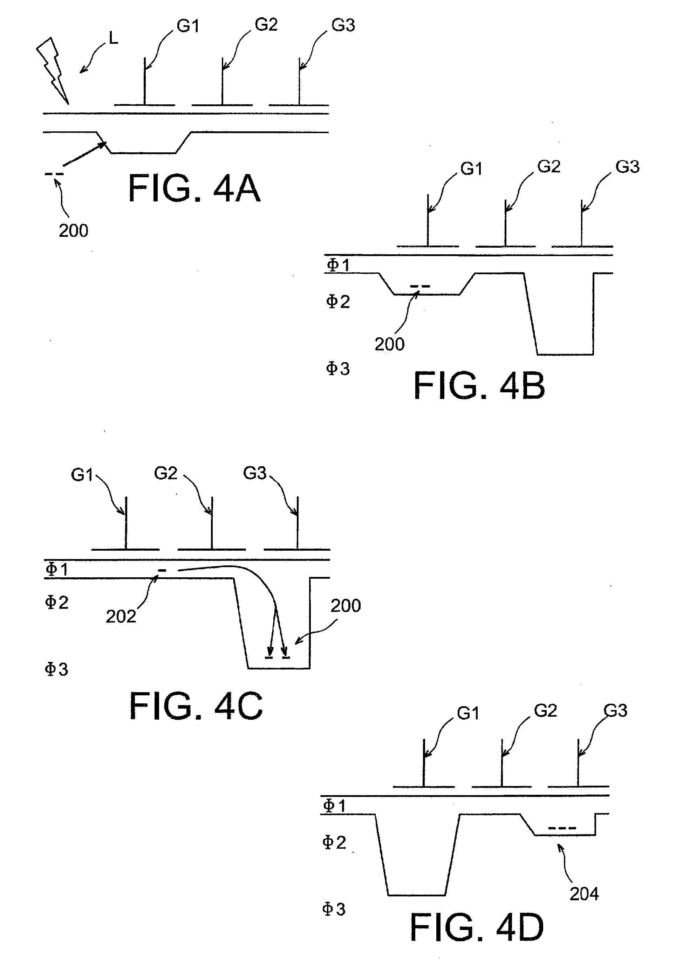

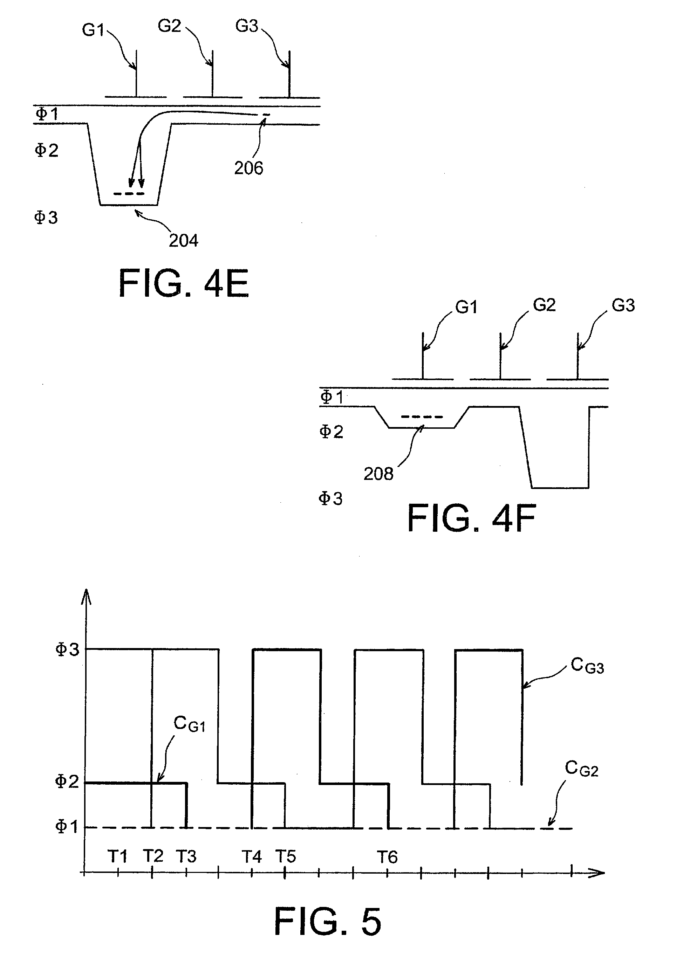

Un exemple de fonctionnement d'un pixel doté d'un multiplicateur d'électrons à avalanche, ainsi que des processus de « multiplication » d'électrons, vont à présent être décrits en liaison avec les figures 4A-4F et la figure 5.

Sur les figures 4A-4F, un multiplicateur avec ses 3 électrodes de grilles G1, G2, G3, est représenté lors de phases de multiplications, avec les barrières ou puits de potentiels générées lors de ces phases dans les zones de canal C1, C2, C3 situées respectivement en regard des électrodes de grilles G1, G2, G3, en fonction d'un premier signal SG1, appliqué sur la première grille G1, d'un deuxième signal SG2, appliqué sur la deuxième grille G2, et d'un troisième signal SG3, appliqué sur la troisième grille G3.

Les signaux SG1, SG2, SG3, sont générés par le circuit de commande 150 et adoptent lors des phases de multiplications, différentes valeurs de potentiels, prévues selon des séquences prédéterminées ou préétablies. Ces séquences de signaux peuvent être prévues en fonction d'un gain de multiplication ou d'amplification souhaité, ou d'une estimation d'un nombre d'électrons que l'on souhaite que le multiplicateur produise.

Sur la figure 5, des chronogrammes C_{G1}, C_{G2}, C_{G3} donnent des exemples de séquences qu'adoptent respectivement les signaux générés sur les grilles G1, G2, G3.

Suite à une exposition de la zone photosensible 110 à un rayonnement lumineux L, un groupe 200 d'électrons a été généré.

On applique tout d'abord (figure 4A et étape T1 sur la figure 5) des potentiels sur les grilles G1, G2, G3, de manière à créer un premier puits de potentiel dans la zone de canal C1 située en regard de la première grille G1 et attirer le groupe d'électrons résultats de la conversion de photons. Pour cela, la première grille G1 peut être mise à un potentiel Φ2, par exemple de l'ordre de 2 volt tandis que la deuxième grille G2 et G1 sont mises à un potentiel Φ1 inférieur à Φ2.

Ensuite (figure 4B et étape T2 sur la figure 5), on forme un deuxième puits de potentiel, plus important que le premier puits, dans la zone de canal C3 en regard de la troisième grille G3, tandis que le canal C2 en regard de la deuxième grille G2 est bloqué. Pour cela, la troisième grille G3 peut être mise à un potentiel Φ3, par exemple de l'ordre de 10 volts supérieurs à Φ2, tandis que la deuxième grille G2 et la première grille G1 sont maintenues respectivement au potentiel Φ1 et au potentiel Φ2.

Puis (figure 4C et début d'une étape T3 sur la figure 5), dans la zone en regard de la première grille G1, la barrière de potentiel est relevée de manière à déplacer le groupe 200 d'électrons en regard de la troisième grille G3 dans le deuxième puits de potentiel. Au cours de ce déplacement, un ou plusieurs électrons 202 supplémentaires sont générés par ionisation par impact. Pour cela, au début de l'étape T3, la première grille G1 peut être mise au potentiel Φ1. Le groupe d'électrons 200 ainsi que les électrons supplémentaires 202 se regroupent alors dans le deuxième puits de potentiel pour former un nouveau groupe 204 d'électrons, plus important que le groupe 200.

Ensuite, le puits de potentiel en regard de la troisième grille G3 est relevé (fin de l'étape T3 sur la figure 5) par exemple en plaçant la troisième grille G3 au potentiel Φ1.

On forme alors (étape T4 sur la figure 5 et figure 4D) un troisième puits de potentiel en regard de la première grille G1, plus important que celui en regard de la troisième grille G3, tandis que la deuxième grille est maintenue au même potentiel. Pour cela, la première grille G1 peut être mise au potentiel Φ3, tandis que la deuxième grille G2 et la troisième grille G3 sont maintenues respectivement au potentiel Φ1 et au potentiel Φ2.

Puis (étape T5 sur la figure 5 et figure 4E), dans la zone en regard de la troisième grille G3, la barrière de potentiel est relevée de manière à déplacer le groupe 204 d'électrons en regard de la troisième grille G3 dans le deuxième puits de potentiel. Pour cela, lors de l'étape T5, la troisième grille G3 peut être mise au potentiel Φ1, tandis que la deuxième grille G2 et la troisième grille G1 sont maintenues respectivement au potentiel Φ1 et au potentiel Φ3. Au cours de ce déplacement, un ou plusieurs électrons 206 supplémentaires sont générés par ionisation par impact. Le groupe d'électrons 204 ainsi que les électrons supplémentaires 206 se regroupent alors dans le puits de potentiel en regard de la première grille pour former un nouveau groupe 208 d'électrons, plus important que le groupe 204.

Ensuite (étape T6 et suivantes sur la figure 5 et figure 4F), le processus de multiplication peut être réitéré.

Des séquences de potentiels appliquées aux grilles G1, G2, G3 ont permis de transférer des électrons situés sous la grille G1 vers le canal situé sous la grille notée G3, puis de les transférer du canal sous la grille G3 vers le canal sous la grille G1. Un transfert bidirectionnel ou aller-retour des électrons dans le multiplicateur 120 a été ainsi effectué. Lors de chaque transfert, la différence de potentiel entre la grille centrale G2 et la grille vers laquelle les électrons sont transférés est prévue de manière à créer un champ électrique dans la zone semi-conductrice en regard des grilles, suffisamment élevé pour déclencher au moins une ionisation par impact lors du transfert d'électrons.

A chaque transfert, le nombre d'électrons est augmenté. Le gain « de multiplication » ou de « multiplication » peut être par exemple de l'ordre de 1 % par transfert. Cette valeur permet d'optimiser le rapport signal/bruit, du dispositif. En augmentant le nombre d'aller-retour entre les grilles G1 et G3, typiquement plusieurs dizaines ou centaines d'allers-retours, le nombre d'électrons peut être fortement multiplié. En fin de processus de multiplication, la quantité d'électrons est transformée en tension par le circuit de lecture 140.

Le gain « d'amplification » ou de « multiplication » ou le nombre d'électrons produits peut être adapté ou modifié en adaptant ou modifiant la séquence de signaux générée et appliquée aux grilles. Une réitération de plusieurs séquences telles que celle décrite précédemment peut par exemple permettre d'augmenter le nombre d'allers-retours effectué par les électrons et augmenter le nombre d'électrons supplémentaires produits par le multiplicateur 120.

La valeur de tension ou d'amplitude nécessaire pour déclencher une ionisation est déterminée notamment par la distance entre les grilles G1, G2, G3, par exemple de l'ordre de 40 nanomètres, le type de dopage, par exemple un dopage P, et la dose de dopage de la zone semi-conductrice en regard des grilles, par exemple de l'ordre de 10¹⁵ atomes/cm³ et par le type de matériau de diélectrique de grille utilisé, par exemple du SiO₂ d'épaisseur de l'ordre de plusieurs nanomètres, par exemple de l'ordre de 3 nanomètres.

Dans une architecture d'imageur suivant l'invention, chaque pixel peut être adressable individuellement, par exemple à l'aide d'un adressage en lignes et colonnes. Chaque multiplicateur 120 peut être piloté ou commandé individuellement à l'aide du circuit de commande 150, de sorte que le gain de chaque multiplicateur 120 peut être adapté ou modifié individuellement.

Des gains d'amplifications ou de multiplication différents sont prévus entre les pixels, par exemple selon leur positionnement dans la matrice, par exemple pour tenir compte des dispersions ou des effets de bord.

Pour appliquer des gains d'amplifications différents d'un pixel ou d'une cellule à l'autre de la matrice, c'est-à-dire effectuer des cycles de multiplications ou d'amplifications du nombre d'électrons avec des gains différents d'un pixel à l'autre, le circuit de commande peut être prévu pour appliquer des séquences de signaux différentes aux grilles des différents pixels. De telles séquences peuvent être générées à l'aide par exemple de circuits logiques.

Il est possible d'appliquer, par exemple, à au moins un premier pixel, une première séquence de signaux aux trois grilles du multiplicateur de ce premier pixel et appliquer, par exemple, à au moins un deuxième pixel, une deuxième séquence de signaux aux trois grilles du multiplicateur de ce deuxième pixel. Selon une possibilité, la deuxième séquence peut être par exemple une répétition d'un nombre donné X, de fois la première séquence. Par exemple, une première séquence de signaux semblable à celle illustrée sur la figure 5 peut être appliquée aux grilles G1, G2, G3 d'un ou plusieurs pixels de l'imageur, tandis qu'une autre séquence de signaux est appliquée aux grilles G1, G2, G3, d'un ou plusieurs pixels de l'imageur, l'autre séquence étant une répétition de la première séquence. Ainsi, en répétant la première séquence, on augmente le nombre d'allers-retours des électrons et de possibilité d'ionisation.

Des gains d'amplifications ou de multiplication différents entre pixels peuvent être appliqués en fonction de la quantité de charge convertie par leur zone photosensible respective.

Le gain d'amplification ou de multiplication d'un pixel peut être modifié et adapté en fonction de la quantité de charge convertie par leur zone photosensible respective, détectée par le circuit de lecture.

Le circuit de lecture 140 peut être agencé de manière à ne pas perturber les électrons présents dans le multiplicateur. Pour cela, un transistor de transfert T₁ peut être prévu entre le multiplicateur 120 et le circuit de lecture 140 ou en entrée du circuit de lecture 140. Lorsque le multiplicateur 120 est relié à la grille d'un transistor suiveur d'un circuit de lecture 3T, ou lorsque le circuit de lecture est un circuit 4T, et que le multiplicateur est par exemple situé entre un transistor de transfert et un suiveur, on peut effectuer plusieurs lectures de la charge présente dans le multiplicateur 120, tout au long d'un cycle d'amplification. Le circuit de lecture peut être ainsi prévu pour effectuer une ou plusieurs lectures du pixel pendant un cycle de multiplication d'électrons.

Un tel fonctionnement permet d'obtenir une dynamique améliorée. Lors d'un cycle de multiplication des électrons, si le signal initial est important, lorsque le pixel est fortement éclairé, pour éviter qu'après un certain nombre de cycles d'amplification, le multiplicateur sature, on peut effectuer plusieurs lectures, par exemple avant tout cycle d'amplification, après N cycles d'amplifications, puis après K*N cycles d'amplifications. Une valeur du signal avant saturation est ainsi disponible, et permet de préserver la dynamique de l'image obtenue.

En effectuant des lectures périodiques, par exemple au moins une première lecture après N cycles d'amplification, et au moins une deuxième lecture après K+N cycles d'amplification, le gain de chaque pixel peut être évalué par le circuit de lecture 140 en comparant la première lecture et la deuxième lecture. Il est ainsi possible d'en déduire précisément le gain du multiplicateur de chaque pixel, et alors de s'affranchir de non-uniformités de gain sur la matrice de pixels, ainsi que les variations de gain dues, par exemple, à des variations de tension d'alimentation, de la température au sein de la matrice.

Un dispositif imageur CMOS à avalanche suivant l'invention, conserve les principaux avantages des imageurs CMOS, telles que la rapidité, la possibilité d'effectuer une lecture partielle de la matrice (i.e. d'un ou plusieurs pixels ou d'une ou plusieurs rangées de la matrice parmi toutes les rangées de pixels), intégration possible de circuit logique au sein du pixel.

On peut également effectuer un échantillonnage de type « correlated double sampling », tel que décrit dans le document « A New Correlated Double Sampling (CDS) Technique for Low Voltage Design Environment in Advanced CMOS Technology », Xu et al., Solid state circuits conference 2002, 24/09/2002, pages 117-120, et qui permet d'améliorer les performances en termes de rapport signal à bruit.

Il est possible d'intégrer le multiplicateur 120 d'électrons à différents endroits d'un pixel ou d'une cellule de l'imageur.

Selon une première possibilité, le multiplicateur peut être intégré directement dans la zone photosensible éclairée, par exemple dans la photodiode.

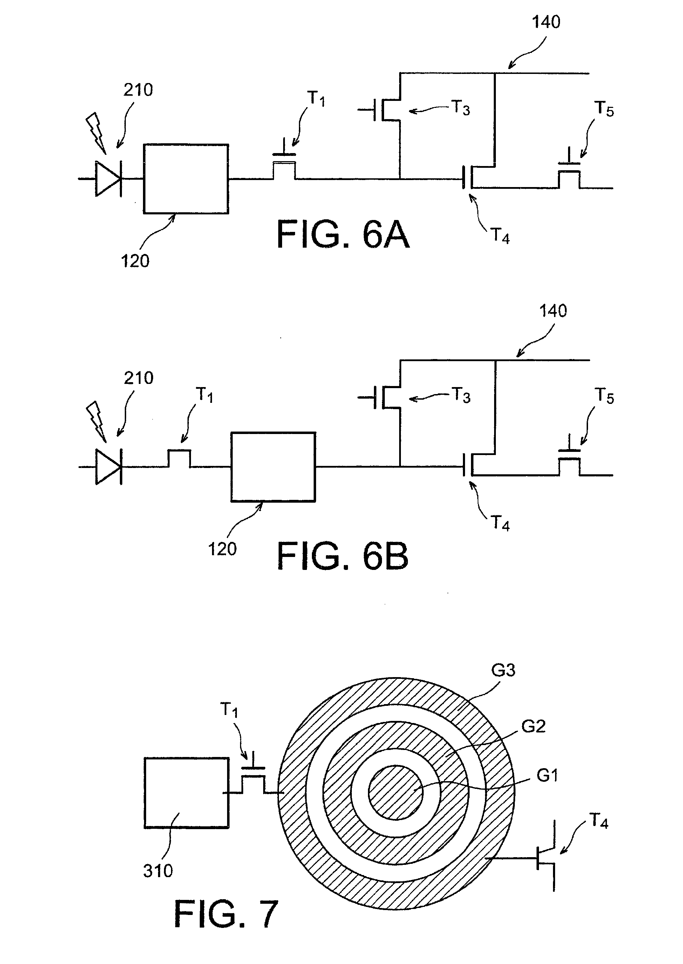

Selon une deuxième possibilité (figure 6A), le multiplicateur 120 peut être placé entre la zone photosensible, par exemple une photodiode 210 et un circuit de lecture 140.

Selon une troisième possibilité (figure 6B), le multiplicateur 120 peut être intégré dans le circuit de lecture 140, par exemple entre un transistor de transfert T₁ de ce circuit et une pluralité de transistors T₂, T₃, T₄, formant un suiveur.

Pour un bon fonctionnement du multiplicateur 120, un nombre d'au moins 3 grilles G1, G2, G3 peut être préférable. Une desdites grilles peut servir à stocker les électrons, une autre grille permet d'appliquer une tension nécessaire pour attirer les électrons et réaliser une ionisation par impact, et une autre grille permet de bloquer le passage des électrons avant que la tension d'ionisation soit atteinte. Dans l'exemple qui a été décrit précédemment, la première grille G1 et la troisième grille G3 remplissent alternativement le rôle de grille de stockage et de grille d'attraction. La deuxième grille G2 peut quant à elle jouer le rôle de blocage des électrons avant que l'énergie d'ionisation soit atteinte.

Des grilles supplémentaires peuvent être éventuellement ajoutées, par exemple pour isoler le multiplicateur de la zone de photosensible 110 ou du circuit de lecture 130.

Selon une possibilité de réalisation, le multiplicateur 120 peut être masqué par un niveau de métal communément appelé « dark métal » par exemple à base d'aluminium ou de cuivre, formé au dessus des grilles G1, G2, G3.

Selon une autre possibilité, le multiplicateur 120 peut être mis en oeuvre dans une zone éclairée. Dans ce cas, des électrons seront photogénérés dans le multiplicateur 120.

La durée d'une étape de multiplication doit être prévue courte devant le temps de capture de l'image, par exemple au moins 100 fois ou au moins 1000 fois plus courte que le temps de capture de l'image.

Pour éviter les effets de bords, ainsi que les contraintes d'une isolation latérale, les grilles G1, G2, G3 peuvent être avoir chacune une forme annulaire. Les grilles G1, G2, G3 peuvent être sous forme de contours concentriques, par exemple de 3 contours concentriques.

Sur la figure 7, un exemple de dispositif microélectronique à détecteur photosensible, doté de moyens multiplicateurs par avalanche électronique comportant plusieurs grilles G1, G2, G3, de contrôle, ayant la forme de cercles concentriques est représenté selon une vue de dessus. Dans cet exemple, un transistor de transfert T₁ (représenté de manière schématique sur cette figure) est prévu entre une zone photosensible 310 et les grilles G1, G2, G3 des moyens multiplicateurs, tandis que la grille G3 qui entoure les deux autres grilles G1 et G2, peut être connectée à l'électrode de grille d'un transistor T4 du circuit de lecture.

L'intégration de plusieurs grilles métalliques dans un pixel pourrait conduire à réduire la surface effectivement photosensible du pixel. Afin d'avoir une surface photosensible plus importante, le pixel d'imageur suivant l'invention peut être réalisé en technologie « aminci retourné » ou « backside », dans laquelle la lumière arrive par une face du pixel, par exemple la face arrière alors que le circuit de lecture et le multiplicateur se trouvent au niveau de l'autre face, par exemple en face avant, ce qui permet de collecter un maximum de photons.

Suivant une variante, les pixels d'imageurs suivant l'invention peuvent être réalisés dans une technologie dite « above IC » telle que décrite dans le document « A highly reliable amorphous photosensor for above IC CMOS image sensor », dans laquelle la zone photosensible est fabriquée par-dessus le circuit de lecture et le multiplicateur d'électrons.

Un dispositif imageur suivant l'invention avec un multiplicateur à avalanche intégré à un pixel, en particulier de type CMOS, permet notamment de s'affranchir des principales limitations des dispositifs CCD à avalanche : telles que le bruit et la variation du gain du multiplicateur en fonction des conditions environnementales, du vieillissement.

## Revendications

1. Dispositif microélectronique matriciel capteur d'image comportant une pluralité de cellules élémentaires (pᵢ) agencées selon une matrice (100)
au moins plusieurs cellules étant dotées chacune d'au moins une zone photosensible (110) de capture de(s) photon(s) et de conversion de(s) photon(s) en électron(s), de moyens multiplicateurs (120) par avalanche électronique prévus, lors d'un cycle dit « de multiplication », pour produire, selon un gain de multiplication, un nombre d'électrons plus important que le nombre d'électrons convertis par la zone photosensible (110), les moyens multiplicateurs étant formées d' au moins une pluralité d'électrodes de grilles (G₁, G₂, G₃) le dispositif microélectronique comprenant en outre un circuit de commande (150) prévu pour appliquer des signaux de commande (SG1, SG2, SG3) aux grilles des moyens multiplicateurs des cellules de la matrice,
le circuit de commande étant configuré pour :
- appliquer des premiers signaux de commande (SG1, SG2, SG3) aux grilles de moyens multiplicateurs d'au moins une première cellule de la matrice, de manière à appliquer un premier gain de multiplication à la dite première cellule de la matrice, et produire en sortie des moyens multiplicateurs de la première cellule un nombre d'électrons plus important que le nombre d'électrons convertis par la zone photosensible de la première cellule,
- appliquer des deuxièmes signaux de commande différents des dits premiers signaux, aux grilles de moyens multiplicateurs d'au moins une deuxième cellule de la matrice, de manière à appliquer à la dite deuxième cellule de la matrice, un deuxième gain de multiplication et produire en sortie des moyens multiplicateurs de la deuxième cellule un nombre d'électrons plus important que le nombre d'électrons convertis par la zone photosensible de ladite deuxième cellule,
le dispositif étant **caractérisé en ce que** ledit deuxième gain de multiplication est différent dudit premier gain de multiplication.

2. Dispositif selon la revendication 1, le circuit de commande comprenant des moyens pour appliquer, au moins un premier signal de commande (SG1) à une première grille (G1) des moyens de multiplication d'une cellule donnée, au moins un deuxième signal de commande (SG2) à une deuxième grille des dits moyens de multiplication de ladite cellule donnée, au moins un troisième signal de commande (SG3) à une troisième grille (G3) des dits moyens de multiplication de ladite cellule donnée, le premier signal (SG1) suivant une première séquence, le deuxième signal (SG2) suivant une deuxième séquence, et le troisième signal (SG3) suivant une troisième séquence, la première séquence, la deuxième séquence, la troisième séquence déterminant le gain de multiplication de la cellule donnée.

3. Dispositif selon la revendication 2, le circuit de commande comprenant en outre des moyens pour modifier la première séquence, la deuxième séquence, et la troisième séquence.

4. Dispositif selon l'une des revendications 1 à 3, dans lequel, les premiers signaux suivent des premières séquences les deuxième signaux suivent des deuxièmes séquences.

5. Dispositif selon la revendication 4, dans lequel les deuxièmes séquences sont une répétition d'un nombre donné X, de fois les premières séquences.

6. Dispositif selon l'une des revendications 1 à 5, les moyens de multiplications d'électrons comportant au moins 3 grilles (G1, G2, G3).

7. Dispositif microélectronique capteur d'image selon l'une des revendications 1 à 6, les cellules comprenant en outre respectivement au moins un circuit de lecture (140) de la quantité de charge(s) produite par au moins une zone photosensible.

8. Dispositif microélectronique capteur d'image selon l'une des revendications 1 à 7, au moins plusieurs cellules comprenant en outre chacune au moins un circuit de lecture (140) de la quantité de charge(s) produite par ladite zone photosensible.

9. Dispositif microélectronique capteur d'image selon l'une des revendications 7 ou 8, le circuit de lecture (140) comprenant, ou étant formé, d'au moins un convertisseur charge/tension ou d'au moins un convertisseur charge/courant.

10. Dispositif microélectronique capteur d'image selon l'une des revendications 7 à 9, les moyens multiplicateurs étant intégrés dans le circuit de lecture.

11. Dispositif microélectronique capteur d'image selon l'une des revendications 7 à 10, les moyens multiplicateurs étant situés entre la zone photosensible et le circuit de lecture.

12. Dispositif microélectronique capteur d'image selon l'une des revendications 7 à 11, le circuit de lecture étant prévu pour effectuer une lecture d'une quantité de charge(s) produite par ladite zone photosensible, préalablement à un cycle de multiplication de cette quantité de charge.

13. Dispositif microélectronique capteur d'image selon l'une des revendications 7 à 12, le circuit de lecture étant prévu pour effectuer une lecture périodique de la quantité de charge(s) produite par ladite zone photosensible.

14. Dispositif microélectronique capteur d'image selon l'une des revendications 7 à 13, ledit circuit de commande comprenant des moyens pour, après une lecture effectuée par le circuit de lecture, modifier le gain d'une ou plusieurs cellules données de la matrice en fonction de la quantité de charge(s) produite par leurs zones photosensibles sensibles respectives et lues par le circuit de lecture.

15. Dispositif microélectronique capteur d'image selon l'une des revendications 1 à 14, comprenant en outre : des moyens d'échantillonnage multiple corrélé.

16. Dispositif microélectronique capteur d'image selon l'une des revendications 1 à 15, dans lequel la zone photosensible est située sur une face donnée ou d'un côté donné d'un substrat, les grilles des moyens multiplicateurs étant formés sur ladite face donnée ou sur ledit côté donné dudit substrat.

17. Dispositif microélectronique capteur d'image selon la revendication 16, dans lequel la zone photosensible recouvre les grilles des moyens multiplicateurs.

18. Dispositif microélectronique capteur d'image selon la revendication 16, dans lequel la zone photosensible et les grilles des moyens multiplicateurs sont juxtaposées.

19. Procédé de commande d'un dispositif microélectronique matriciel capteur d'image comportant une pluralité de cellules élémentaires (pᵢ) agencées selon une matrice (100),
au moins plusieurs cellules étant dotées chacune d'au moins une zone photosensible (110) de capture de(s) photon(s) et de conversion de(s) photon(s) en électron(s), de moyens multiplicateurs (120) par avalanche électronique prévus, lors d'un cycle dit « de multiplication », pour produire, selon un gain de multiplication, un nombre d'électrons plus important que le nombre d'électrons convertis par la zone photosensible (110), les moyens multiplicateurs étant formées d'au moins une pluralité d'électrodes de grilles (G₁, G₂, G₃), le dispositif microélectronique comprenant en outre un circuit de commande (150) pour appliquer des signaux de commande (SG1, SG2, SG3) aux grilles des moyens multiplicateurs des cellules de la matrice,
le procédé de commande comprenant des étapes de :
- application de premiers signaux de commande (SG1, SG2, SG3) aux grilles de moyens multiplicateurs d'au moins une première cellule de la matrice, de manière à appliquer un premier gain de multiplication à la dite premières cellule de la matrice et produire en sortie desdits moyens multiplicateurs de ladite première cellule un nombre d'électrons plus important que le nombre d'électrons convertis par la zone photosensible de la première cellule,
- application de deuxièmes signaux de commande différents des dits premiers signaux, aux grilles de moyens multiplicateurs d'au moins une deuxième cellule de la matrice, de manière à appliquer à la dite deuxième cellule de la matrice, un deuxième gain de multiplication et produire en sortie des moyens multiplicateurs de la deuxième cellule un nombre d'électrons plus important que le nombre d'électrons convertis par la zone photosensible de ladite deuxième cellule,
le procédé étant **caractérisé en ce que** ledit deuxième gain de multiplication est différent dudit premier gain de multiplication.

20. Procédé selon la revendication 19, le procédé de commande comprenant des étapes consistant à appliquer au moins un premier signal de commande (SG1) à une première grille (G1) des moyens de multiplication d'une cellule donnée, au moins un deuxième signal de commande (SG2) à une deuxième grille des dits moyens de multiplication de ladite cellule donnée, au moins un troisième signal de commande (SG3) à une troisième grille (G3) des dits moyens de multiplication de ladite cellule donnée, le premier signal (SG1) suivant une première séquence, le deuxième signal (SG2) suivant une deuxième séquence, et le troisième signal (SG3) suivant une troisième séquence, la première séquence, la deuxième séquence, et la troisième séquence déterminant le gain de multiplication de la cellule donnée.

21. Procédé selon la revendication 20, le procédé de commande comprenant une étape consistant à modifier la première séquence, la deuxième séquence, et la troisième séquence.

22. Procédé selon l'une des revendications 19 à 21, comprenant une étape de lecture d'une quantité de charge(s) produite par ladite zone photosensible, préalablement à un cycle de multiplication de cette quantité de charge.

23. Procédé selon l'une des revendications 19 à 22, comprenant une étape consistant à, après une lecture effectuée par le circuit de lecture, modifier le gain d'une ou plusieurs cellules données de la matrice en fonction de la quantité de charge(s) produite par leurs zones photosensibles sensibles respectives et lues par le circuit de lecture.

## Patentansprüche

1. Matrixförmige mikroelektronische Bildsensor-Vorrichtung mit einer Vielzahl gemäß einer Matrix (100) angeordneter Elementarzellen (pᵢ), jede von wenigstens mehreren Zellen wenigstens eine fotosensible Zone (110) für den Photon(en)fang und zur Photon(en)-Elektron(en)-Konversion umfassend,
mit Elektronenlawinenmultiplikationseinrichtungen (120), vorgesehen um während eines so genannten "Multiplikationszyklus" gemäß einer Multiplikationsverstärkung eine größere Anzahl Elektronen als die Anzahl der durch die fotosensible Zone (110) konvertierten Elektronen zu erzeugen, wobei die Multiplikationseinrichtungen durch wenigstens eine Vielzahl Gateelektroden (G₁, G₂, G₃) gebildet werden und die mikroelektronische Vorrichtung außerdem eine Steuerschaltung (150) umfasst, vorgesehen um Steuersignale (SG1, SG2, SG3) an die Gates der Multiplikationseinrichtungen der Zellen der Matrix anzulegen,
wobei die Steuerschaltung konfiguriert ist, um :
- erste Steuersignale (SG1, SG2, SG3) an die Gates von Multiplikationseinrichtungen von wenigstens einer ersten Zelle der Matrix anzulegen, um eine erste Multiplikationsverstärkung an die genannte erste Zelle der Matrix anzulegen und am Ausgang der Multiplikationseinrichtungen der ersten Zelle eine größere Anzahl Elektronen als die Anzahl der durch die fotosensible Zone der ersten Zelle konvertierten Elektronen zu erzeugen,
- zweite Steuersignale, unterschiedlich zu den ersten Steuersignalen, an die Gates von Multiplikationseinrichtungen von wenigstens einer zweiten Zelle der Matrix anzulegen, um an die genannte zweite Zelle der Matrix eine zweite Multiplikationsverstärkung anzulegen und am Ausgang der Multiplikationseinrichtungen der zweiten Zelle eine größere Anzahl Elektronen als die Anzahl der durch die fotosensible Zone der zweiten Zelle konvertierten Elektronen zu erzeugen,
wobei die Vorrichtung **dadurch gekennzeichnet ist, dass** die genannte zweite Multiplikationsverstärkung sich von der genannten ersten Multiplikationsverstärkung unterscheidet.

2. Vorrichtung nach Anspruch 1, wobei die Steuerschaltung Einrichtungen zum Anlegen wenigstens eines ersten Steuersignals (SG1) an ein erstes Gate (G1) der Multiplikationseinrichtungen einer gegebenen Zelle und wenigstens eines zweiten Steuersignals (SG2) an ein zweites Gate der genannten Multiplikationseinrichtungen der genannten gegebenen Zelle sowie wenigstens eines dritten Steuersignals (SG3) an ein drittes Gate (G3) der genannten Multiplikationseinrichtungen der genannten gegebenen Zelle umfasst; das erste Signal (SG1) gemäß einer ersten Sequenz, das zweite Signal (SG2) gemäß einer zweiten Sequenz, das dritte Signal (SG1) gemäß einer dritten Sequenz, wobei die erste Sequenz, die zweite Sequenz und die dritte Sequenz die Multiplikationsverstärkung der gegebenen Zelle bestimmt.

3. Vorrichtung nach Anspruch 2, wobei die Steuerschaltung außerdem Einrichtungen zum Modifizieren der ersten Sequenz, der zweiten Sequenz und der dritten Sequenz umfasst.

4. Vorrichtung nach einem der Ansprüche 1 bis 3, bei der die ersten Signale ersten Sequenzen folgen, die zweiten Signale zweiten Sequenzen folgen.

5. Vorrichtung nach Anspruch 4, bei der die zweiten Sequenzen eine Wiederholung einer gegebenen Größe X mal die ersten Sequenzen sind.

6. Vorrichtung nach einem der Ansprüche 1 bis 5, wobei die Elektronenmultiplikationseinrichtungen wenigstens 3 Gates (G1, G2, G3) umfassen.

7. Mikroelektronische Bildsensorvorrichtung nach einem der Ansprüche 1 bis 6, wobei die Zellen außerdem jeweils eine Ausleseschaltung (140) der durch wenigstens eine fotosensible Zone erzeugten Ladungsmenge(Menge von Ladungen) umfasst.

8. Mikroelektronische Bildsensorvorrichtung nach einem der Ansprüche 1 bis 7, wobei jede von wenigstens mehreren Zellen wenigstens eine Ausleseschaltung (140) der durch die genannte fotosensible Zone erzeugten Ladungsmenge(Menge von Ladungen) umfasst.

9. Mikroelektronische Bildsensorvorrichtung nach einem der Ansprüche 7 oder 8, wobei die Ausleseschaltung (140) umfasst oder gebildet wird durch wenigstens einen Ladungs-Spannungs-Wandler oder wenigstens einen Ladungs-Strom-Wandler.

10. Mikroelektronische Bildsensorvorrichtung nach einem der Ansprüche 7 bis 9, wobei die Multiplikationseinrichtungen in die Ausleseschaltung integriert sind.

11. Mikroelektronische Bildsensorvorrichtung nach einem der Ansprüche 7 bis 10, wobei die Multiplikationseinrichtungen sich zwischen der fotosensiblen Zone und der Ausleseschaltung befinden.

12. Mikroelektronische Bildsensorvorrichtung nach einem der Ansprüche 7 bis 11, wobei die Ausleseschaltung vorgesehen ist, um ein Auslesen einer Ladungsmenge(Menge von Ladungen), erzeugt durch die fotosensible Zone, vor einem Multiplikationszyklus dieser Ladungsmenge durchzuführen.

13. Mikroelektronische Bildsensorvorrichtung nach einem der Ansprüche 7 bis 12, wobei die Ausleseschaltung vorgesehen ist, um ein periodisches Auslesen dieser durch die genannte fotosensible Zone erzeugten Ladungsmenge(Menge von Ladungen) durchzuführen.

14. Mikroelektronische Bildsensorvorrichtung nach einem der Ansprüche 7 bis 13, wobei die genannte Steuerschaltung Einrichtungen umfasst, um nach einem durch die Ausleseschaltung durchgeführten Auslesen die Verstärkung von einer oder mehreren gegebenen Zellen der Matrix zu ändern in Abhängigkeit von der durch ihre jeweiligen fotosensiblen Zonen erzeugten und durch die Ausleseschaltung ausgelesenen Ladungsmenge(Menge von Ladungen).

15. Mikroelektronische Bildsensorvorrichtung nach einem der Ansprüche 1 bis 14, außerdem Einrichtungen zur korrelierten Mehrfachabtastung umfassend.

16. Mikroelektronische Bildsensorvorrichtung nach einem der Ansprüche 1 bis 15, bei der sich die fotosensible Zone auf einer bestimmten Fläche oder einer bestimmten Seite eines Substrats befindet, wobei die Gates der Multiplikationseinrichtungen auf der genannten bestimmten Fläche oder auf der genannten bestimmten Seite des genannten Substrats ausgebildet sind.

17. Mikroelektronische Bildsensorvorrichtung nach Anspruch 16, bei der die fotosensible Zone die Gates der Multiplikationseinrichtungen überdeckt.

18. Mikroelektronische Bildsensorvorrichtung nach Anspruch 16, bei der die fotosensible Zone und die Gates der Multiplikationseinrichtungen nebeneinander liegen.

19. Verfahren zur Steuerung einer matrixförmigen mikroelektronischen Bildsensorvorrichtung mit einer Vielzahl gemäß einer Matrix (100) angeordneter Elementarzellen (pᵢ), jede von wenigstens mehreren Zellen wenigstens eine fotosensible Zone (110) für den Photon(en)fang und zur Photon(en)-Elektron(en)-Konversion umfassend,
wobei Elektronenlawinenmultiplikationseinrichtungen (120) während eines so genannten "Multiplikationszyklus" gemäß einer Multiplikationsverstärkung eine größere Anzahl Elektronen als die Anzahl der durch die fotosensible Zone (110) konvertierten Elektronen erzeugen, wobei die Multiplikationseinrichtungen durch wenigstens eine Vielzahl Gateelektroden (G₁, G₂, G₃) gebildet werden und die mikroelektronische Vorrichtung außerdem eine Steuerschaltung (150) umfasst, vorgesehen um Steuersignale (SG1, SG2, SG3) an die Gates der Multiplikationseinrichtungen der Zellen der Matrix anzulegen,
wobei das Steuerungsverfahren Schritte umfasst, um :
- erste Steuersignale (SG1, SG2, SG3) an die Gates von Multiplikationseinrichtungen von wenigstens einer ersten Zelle der Matrix anzulegen, um eine erste Multiplikationsverstärkung an die genannte erste Zelle der Matrix anzulegen und am Ausgang der Multiplikationseinrichtungen der ersten Zelle eine größere Anzahl Elektronen als die Anzahl der durch die fotosensible Zone der ersten Zelle konvertierten Elektronen zu erzeugen,
- zweite Steuersignale, unterschiedlich zu den ersten Steuersignalen, an die Gates von Multiplikationseinrichtungen von wenigstens einer zweiten Zelle der Matrix anzulegen, um an die genannte zweite Zelle der Matrix eine zweite Multiplikationsverstärkung anzulegen und am Ausgang der Multiplikationseinrichtungen der zweiten Zelle eine größere Anzahl Elektronen als die Anzahl der durch die fotosensible Zone der zweiten Zelle konvertierten Elektronen zu erzeugen,
wobei das Verfahren **dadurch gekennzeichnet ist, dass** die genannte zweite Multiplikationsverstärkung sich von der genannten ersten Multiplikationsverstärkung unterscheidet.

20. Verfahren nach Anspruch 19, wobei das Steuerungsverfahren Schritte zum Anlegen wenigstens eines ersten Steuersignals (SG1) an ein erstes Gate (G1) der Multiplikationseinrichtungen einer gegebenen Zelle und wenigstens eines zweiten Steuersignals (SG2) an ein zweites Gate der genannten Multiplikationseinrichtungen der genannten gegebenen Zelle sowie wenigstens eines dritten Steuersignals (SG3) an ein drittes Gate (G3) der genannten Multiplikationseinrichtungen der genannten gegebenen Zelle umfasst; das erste Signal (SG1) gemäß einer ersten Sequenz, das zweite Signal (SG2) gemäß einer zweiten Sequenz, das dritte Signal (SG1) gemäß einer dritten Sequenz, wobei die erste Sequenz, die zweite Sequenz und die dritte Sequenz die Multiplikationsverstärkung der gegebenen Zelle bestimmt.

21. Verfahren nach Anspruch 20, wobei das Steuerungsverfahren einen darin bestehenden Schritt umfasst, die erste Sequenz, die zweite Sequenz und die dritte Sequenz zu ändern.

22. Verfahren nach einem der Ansprüche 19 bis 21, umfassend einen Schritt zum Auslesen einer durch die genannte fotosensible Zone erzeugten Ladungsmenge(Menge von Ladungen) vor einem Multiplikationszyklus dieser Ladungsmenge.

23. Verfahren nach einem der Ansprüche 19 bis 22, umfassend einen darin bestehenden Schritt, nach einem durch die Ausleseschaltung durchgeführten Auslesen die Verstärkung von einer oder mehreren gegebenen Zellen der Matrix zu ändern in Abhängigkeit von der durch ihre jeweiligen fotosensiblen Zonen erzeugten und durch die Ausleseschaltung ausgelesenen Ladungsmenge(Menge von Ladungen).

## Claims

1. Microelectronic image sensor array device comprising a plurality of elementary cells (Pi) laid out according to an array (100),
at least several cells each being provided with at least one photosensitive zone (110) for capturing photon(s) and converting photon(s) into electron(s), electronic avalanche multiplier means (120) provided, during a cycle known as a "multiplication" cycle, to produce, according to a multiplication gain, a higher number of electrons than the number of electrons converted by the photosensitive zone, the multiplier means being formed of at least a plurality of gate electrodes (G1, G2, G3), the device further comprising a control circuit to apply control signals to the gates of the multiplier means of the cells of the array,
the control circuit being adapted to:
- apply first control signals (SG1, SG2, SG3) to the gates of multiplier means of at least one first cell of the array, so as to apply a first multiplication gain to said first cell and to produce at the output of the multiplier means of said first cell a number of electrons that is higher than the number of electrons converted by the photosensitive zone of said first cell,
- and to apply second control signals, different from the first signals, to the gates of multiplier means of at least one second cell of the array, so as to apply a second multiplication gain to said second cell and to produce at the output of the multiplier means of said second cell a number of electrons that is higher than the number of electrons converted by the photosensitive zone of said second cell, the device being **characterized in that** second multiplication gain is different from said first multiplication gain.

2. Microelectronic image sensor device according to claim 1, said control circuit of said gates being provided to apply at least one first control signal (SG1) to a first gate of the multiplication means of a given cell, at least one second control signal (SG2) of said multiplication means of said given cell, at least one third control signal (SG3) to a third gate of said multiplication means of said given cell, the first signal (SG1) according to a first sequence, the second signal (SG2) according to a second sequence, and the third signal (SG3) according to a third sequence, the first sequence, the second sequence and the third sequence being provided as a function of a desired multiplication gain.

3. Microelectronic image sensor device according to claim 2, wherein the control circuit of said gates is adapted to modify the first sequence, the second sequence and the third sequence.

4. Microelectronic image sensor device according to any of the claims 1 to 3, wherein the first signals follow first sequences and the second signals follow second sequences.

5. Microelectronic image sensor device according to claim 4, wherein the second sequences are a repetition of a given number X, times the first sequences.

6. Microelectronic image sensor device according to claim 1, wherein the electron multiplication means comprise at least 3 gates (G1, G2, G3).

7. Microelectronic image sensor device according to any of the claims 1 to 6, at least several cells each further comprising: at least one reading circuit (140) of the quantity of charge(s) produced by said photosensitive zone.

8. Microelectronic image sensor device according to any of the claims 1 to 7, wherein the reading circuit comprises, or is formed, of at least one charge/voltage converter or at least one charge/current converter.

9. Microelectronic image sensor device according to claim 7 or 8, wherein the multiplier means are integrated in the reading circuit.

10. Microelectronic image sensor device according to any of the claims 7 to 9, wherein the multiplier means are situated between the photosensitive zone and the reading circuit.

11. Microelectronic image sensor device according to any of the claims 7 to 10, wherein the reading circuit is provided to carry out a reading of a quantity of charge(s) produced by said photosensitive zone, prior to a multiplication cycle of this quantity of charge.

12. Microelectronic image sensor device according to any of the claims 7 to 11, wherein the reading circuit is provided to carry out a periodic reading of the quantity of charge(s) produced by said photosensitive zone.

13. Microelectronic image sensor device according to any of the claims 7 to 12, further comprising at least one reading circuit of the quantity of charge(s) produced by at least one photosensitive zone, said control circuit being adapted so as to modify, after a reading carried out by the reading circuit, the gain of one or several given cells of the array as a function of the quantity of charge(s) produced by their respective sensitive photosensitive zones.

14. Microelectronic image sensor device according to any of the claims 7 to 13, said control circuit being adapted to modify, after a reading carried out by the reading circuit, the gain of one or several given cells of the array as a function of the quantity of charge(s) produced by their respective sensitive photosensitive zones.

15. Microelectronic image sensor device according to any of the claims 1 to 14, further comprising: correlated multiple sampling means.

16. Microelectronic image sensor device according to any of the claims 1 to 15, wherein the photosensitive zone is situated on a given face or a given side of a substrate, wherein the gates of the multiplier means are formed on said given face or on said given side of said substrate.

17. Microelectronic image sensor device according to claim 16, wherein the photosensitive zone overlays the gates of the multiplier means.

18. Microelectronic image sensor device according to claim 16, wherein the photosensitive zone and the gates of the multiplier means are juxtaposed.

19. Method for controlling an image sensor array device comprising a plurality of elementary cells (Pi) laid out according to an array (100),
at least several cells each being provided with at least one photosensitive zone (110) for capturing photon(s) and converting photon(s) into electron(s), electronic avalanche multiplier means (120) provided, during a cycle known as a "multiplication" cycle, to produce, according to a multiplication gain, a higher number of electrons than the number of electrons converted by the photosensitive zone, the multiplier means being formed of at least a plurality of gate electrodes (G1, G2, G3), the device further comprising a control circuit to apply control signals to the gates of the multiplier means of the cells of the array,
the method comprising steps of :
- applying first control signals (SG1, SG2, SG3) to the gates of multiplier means of at least one first cell of the array, so as to apply a first multiplication gain to said first cell and to produce at the output of the multiplier means of said first cell a number of electrons that is higher than the number of electrons converted by the photosensitive zone of said first cell,
- applying second control signals, different from the first signals, to the gates of multiplier means of at least one second cell of the array, so as to apply a second multiplication gain to said second cell and to produce at the output of the multiplier means of said second cell a number of electrons that is higher than the number of electrons converted by the photosensitive zone of said second cell, the method being **characterized in that** second multiplication gain is different from said first multiplication gain.

20. Method according to claim 19, said controlling method comprising steps consisting of applying at least one first control signal (SG1) to a first gate of the multiplication means of a given cell, at least one second control signal (SG2) of said multiplication means of said given cell, at least one third control signal (SG3) to a third gate of said multiplication means of said given cell, the first signal (SG1) according to a first sequence, the second signal (SG2) according to a second sequence, and the third signal (SG3) according to a third sequence, the first sequence, the second sequence and the third sequence being provided as a function of a desired multiplication gain.

21. Method according to claim 20, said controlling method comprising steps consisting of modifying the first sequence, the second sequence and the third sequence.

22. Method according to any of the claims 19 to 21, comprising at least one reading step of the quantity of charge(s) produced by said photosensitive zone, prior to a multiplication cycle of this quantity of charge.

23. Method according to any of the claims 19 to 22, further comprising a steps consisting of, after a reading carried out by the reading circuit, modifying the gain of one or several given cells of the array as a function of the quantity of charge(s) produced by their respective sensitive photosensitive zones and read by the reading circuit.
